# EUROPEAN PATENT APPLICATION

(11) **EP 2 293 359 A1**
(43) Date of publication of application: **09.03.2011**
(21) Application number: 10171859.1
(22) Date of filing: 04.08.2010
(51) Int. Cl.: H01L 51/52, H01G 9/20, C03C 27/10

(54) **Sealant, dye-sensitized solar cell including the sealant, and method of manufacturing the dye-sensitized solar cell**

(30) Priority: 03.09.2009 KR 20090083157
(71) Applicant: Samsung SDI Co., Ltd., Gyeonggi-do (KR)
(72) Inventor: Yang, Nam-Choul, Gyeonggi-do (KR); Lee, Ji-Won, Gyeonggi-do (KR); Park, Won-Shik, Gyeonggi-do (KR); Park, Kyung-Do, Gyeonggi-do (KR)
(74) Representative: Gulde Hengelhaupt Ziebig & Schneider

(57) **Abstract**

A sealant disposed between two substrates to be sealed, the sealant comprising: at least two layers disposed layered on top of each other between the two substrates, wherein the at least two layers comprise materials having different components and at least one layer selected from the at least two layers includes a thermoplastic glass frit. A dye-sensitized solar cell including the sealant, and a method of manufacturing a dye-sensitized solar cell are also provided.

## Description

### BACKGROUND OF THE INVENTION

### Filed of the Invention

One or more embodiments of the present invention relate to a sealant for sealing an electrolyte solution included in a dye-sensitized solar cell, a dye-sensitized solar cell including the an electrolyte solution, and a method of manufacturing a dye-sensitized solar cell.

### SUMMARY OF THE INVENTION

Solar energy has been spotlighted as one of the renewable energy sources to replace energy obtained from oil, coal, and natural gas. According to their manufacturing materials, solar cells are classified into silicon solar cells and compound semiconductor solar cells. Single crystal silicon solar cells, poly crystal silicon solar cells, amorphous silicon solar cells, and the like have been commercialized. Single crystal silicon solar cells have an energy efficiency of about 18%, poly crystal silicon solar cells have an energy efficiency of about 15%, and amorphous silicon solar cells have an energy efficiency of about 10%. Silicon solar cells are formed of a semiconductor material and generate electricity by opto-electric conversion.

Meanwhile, dye-sensitized solar cells generate electricity by photosynthesis according to a photo-electrochemical conversion mechanism. Dye-sensitized solar cells have an energy conversion efficiency higher than about 11%. Dye-sensitized solar cells have a theoretical conversion efficiency higher than silicon solar cells, which increases the actual energy conversion efficiency and reduces the manufacturing costs thereof to 1/5. Thus, dye-sensitized solar cells can be used in a wide range of applications.

When dye-sensitized solar cells absorb sunlight, electrons are transported in dye molecules, and are injected into a conduction band of a semiconductor oxide. Then, the injected electrons pass through interfaces between particles of an oxide electrode and reach a conductive film. Thereafter, holes generated in the dye molecules are filled with electrons supplied by an electrolyte placed between two substrates sealed with a sealant, thereby generating a current.

### SUMMARY

Additional aspects will be set forth in part in the description which follows and, in part, will be apparent from the description, or may be learned by practice of the presented embodiments.

According to one or more embodiments of the present invention, a sealant is disposed between two substrates to be sealed, the sealant including: at least two layers disposed layered on top of each other between two substrates, wherein the at least two layers each include materials having different components, and at least one of the at least two layers includes a thermoplastic glass frit.

In one embodiment, one of the at least two sealing layers fills a major portion of the space between the two substrates, and a laser sealing operation is performed on another sealing layer, or another sealing layer is formed of an organic-based resin material. This can reduce problems that occur when the laser sealing operation is performed on a single sealant layer, or a single sealant layer is formed of an organic-based resin material.

Each of the at least two layers may include a thermoplastic glass frit and one of the at least two layers may further include a laser absorption material.

A laser sealing operation may be performed on one of the at least two sealing layers, thereby obtaining a sealant having high sealing quality and having uniform thickness, compared to the case where a single sealant layer has a laser sealing operation performed on it.

One of the at least two layers may include a thermoplastic glass frit and another layer may comprise an organic-based resin material.

When one of the at least two layers is formed of an organic-based resin material, this thereby prevents an electrolyte component from diffusing or being transmitted and being discharged externally, compared to the case where a single sealant layer is formed of an organic-based resin material.

When one of the at least two layers does not include a laser absorption material and is a first sealing layer, and another layer includes a laser absorption material and is a second sealing layer, one of the at least two layers including a thermoplastic glass frit may be the first sealing layer, and another layer including an organic-based resin material may be the second sealing layer, the thickness of the first sealing layer may be greater than or equal to the thickness of the second sealing layer.

One of the at least two layers including a thermoplastic glass frit may be the first sealing layer, and another layer including an organic-based resin material may be the second sealing layer, the thickness of the first sealing layer may be greater than or equal to a thickness of the second sealing layer.

The thickness of a layer on which a laser sealing operation is performed, or a layer including an organic-based resin material, is reduced as much as possible, thereby obtaining a sealant having uniform thickness, and achieving excellent quality of sealing.

The laser absorption material may include one selected from the group consisting of manganese (Mn), iron (Fe), vanadium (V), chromium (Cr), nickel (Ni), cobalt (Co), copper (Cu), and combinations thereof. The organic-based resin material may include one selected from the group consisting of an epoxy resin material, an acrylic resin material, an olefin-acrylic based resin material, an olefin-acrylic-ion based resin material, an olefin-based resin material, and combinations thereof.

According to one or more embodiments of the present invention, a dye-sensitized solar cell includes: a first substrate and a second substrate disposed to face each other; a first electrode and a second electrode formed on the inner surfaces of the first substrate and the second substrate, respectively, that face each other; an electrolyte solution filled between the first substrate and the second substrate; and a sealant disposed on the periphery of inner surfaces of the first substrate and the second substrate to seal the electrolyte solution, and comprising a first sealing layer and a second sealing layer, and the first sealing layer contacting the inner surface of the first substrate and the second sealing layer contacting the inner surface of the second substrate, wherein the first electrode comprises a semiconductor oxide layer onto which a plurality of dye molecules are adsorbed, at least one of the first sealing layer or the second sealing layer including a thermoplastic glass frit, and the first sealing layer and the second sealing layer comprise materials having different components.

The first sealing layer and the second sealing layer may include a thermoplastic glass frit, and the second sealing layer may further include a laser absorption material.

The first sealing may include a thermoplastic glass frit, and the second sealing layer may include an organic-based resin material.

A thickness of the first sealing layer may be between about 50 µm and about 150 µm and a thickness of the second sealing layer may be between about 3 µm and about 50 µm.

According to one or more embodiments of the present invention, a method of manufacturing a dye-sensitized solar cell, the method including: forming a first electrode on a first substrate; forming a second electrode on a second substrate facing the first substrate; forming a first sealing layer on an inner surface of the first substrate or the second substrate; forming a second sealing layer on an inner surface of the first sealing layer or on a region of the second substrate corresponding to the first sealing layer; aligning and sealing the first substrate and the second substrate; and injecting an electrolyte solution between the first substrate and the second substrate, wherein the first sealing layer and the second sealing layer comprise materials having different components, and at least the first sealing layer comprises a thermoplastic glass frit.

The second sealing layer may comprise a thermoplastic glass frit and a laser absorption material. The thickness of the first sealing layer may be greater than or equal to the thickness of the second sealing layer. The thickness of the first sealing layer may be between about 50 µm and about 150 µm and the thickness of the second sealing layer may be between about 3 µm and about 50 µm. The laser absorption material may comprise one selected from the group consisting of manganese (Mn), iron (Fe), vanadium (V), chromium (Cr), nickel (Ni), cobalt (Co), copper (Cu), and combinations thereof.

The second sealing layer may comprise an organic-based resin material. The thickness of the first sealing layer may be greater than or equal to the thickness of the second sealing layer. The thickness of the first sealing layer may be between about 50 µm and about 150 µm and the thickness of the second sealing layer may be between about 3 µm and about 50 µm. The organic-based resin material may comprise one selected from the group consisting of an epoxy resin material, an acrylic resin material, an olefin-acrylic based resin material, an olefin-acrylic-ion based resin material, an olefin-based resin material, and combinations thereof.

### BRIEF DESCRIPTION OF THE DRAWINGS

These and/or other aspects will become apparent and more readily appreciated from the following description of the embodiments, taken in conjunction with the accompanying drawings of which:

FIG. 1 is a diagram illustrating the operation of a dye-sensitized solar cell according to an embodiment of the present invention;

FIG. 2 is a schematic cross-sectional view of a dye-sensitized solar cell sealed by a sealant according to an embodiment of the present invention;

FIG. 3 is a flowchart illustrating a method of manufacturing a dye-sensitized solar cell according to an embodiment of the present invention;

FIGS. 4A through 4E are diagrams illustrating a method of forming a sealant according to an embodiment of the present invention; and

FIGS. 5A through 5E are diagrams illustrating a method of forming a sealant according to another embodiment of the present invention.

### DETAILED DESCRIPTION OF THE INVENTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description.

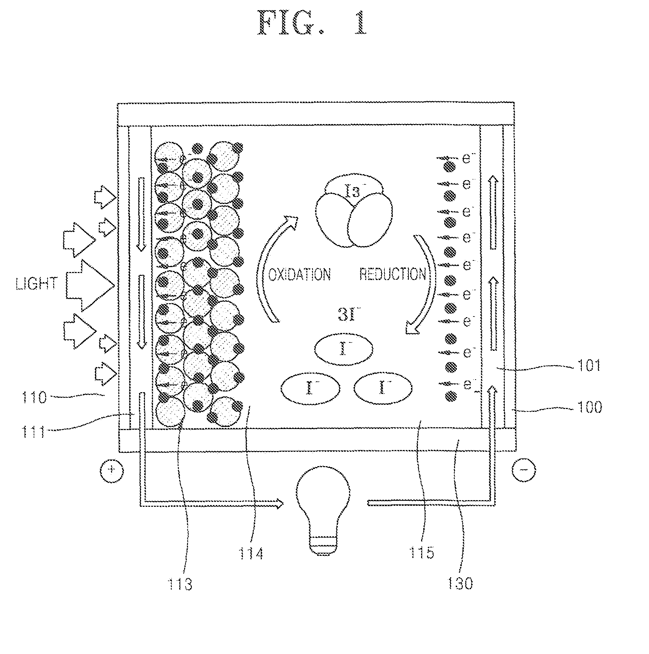

FIG. 1 is a diagram showing the operation of a dye-sensitized solar cell according to an embodiment of the present invention. Referring to FIG. 1, when sunlight is incident onto the dye-sensitized solar cell, dye molecules 114 adsorbed on the surface of a semiconductor oxide layer 113 transit from a highest occupied molecular orbital (HOMO) energy level to a lowest unoccupied molecular orbital (LUMO) energy level and thus electrons are generated. That is, a pair of electron and hole of the dye molecules 114 are separated from each other so that electrons and holes are generated, the electrons are discharged, and the dye molecules 114 are oxidized. The electrons are injected into the conduction band of the semiconductor oxide layer 113 and pass through interfaces between particles of the semiconductor oxide layer 113 to reach a conductive film 111 according to a chemical diffusion gradient. Meanwhile, holes generated at the HOMO energy level of the dye molecules 114 are filled with electrons received from iodine ions 3I⁻ in an electrolyte 115. The iodine ions 3I⁻ provide the holes with the electrons and are oxidized. The iodine ions 3I⁻ oxidized in the electrolyte 115 are reduced by electrons received from an opposite electrode 101 through an external electrical circuit. Thus, when the dye-sensitized solar cell absorbs sunlight, electrons circulate therein so that a current flows in the dye-sensitized solar cell.

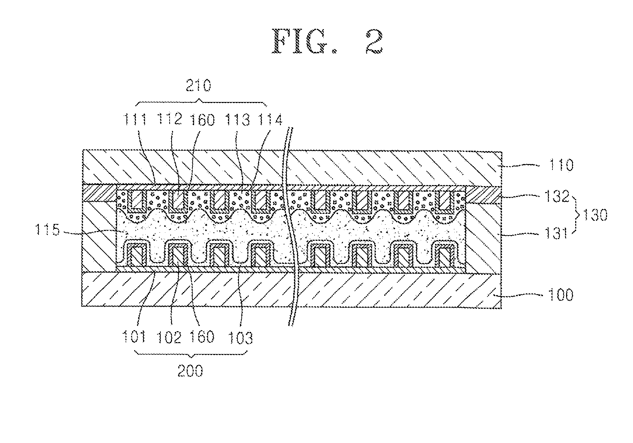

FIG. 2 is a schematic cross-sectional view of a dye-sensitized solar cell including a sealant 130 according to an embodiment of the present invention.

The sealant 130 will now be described in conjunction with the whole structure of the dye-sensitized solar cell. Referring to FIG. 2, the dye-sensitized solar cell includes a first substrate 110, a second substrate 100, a first electrode 210, a second electrode 200, an electrolyte solution 115, and the sealant 130.

The first electrode 210 is formed on the first substrate 110 and may be a photocathode electrode that serves as a cathode. The second electrode 200 is formed on the second substrate 100 and may be an opposite electrode that serves as an anode. The first substrate 110 and the second substrate 100 are transparent. The electrolyte solution 115 is filled between the photocathode electrode 210 and the opposite electrode 200. The first substrate 110 and the second substrate 100 are sealed with the sealant 130 to prevent the electrolyte solution 115 from leaking.

The photocathode electrode 210 may include a first transparent conductive layer 111 formed on the first substrate 110, a plurality of first grid electrodes 112 formed on the first transparent conductive layer 111, a protection film 160 covering the first grid electrodes 112, a nano-sized semiconductor oxide layer 113, and a plurality of dye molecules 114 adsorbed onto the nano-sized semiconductor oxide layer 113.

The first substrate 110 may be formed of a transparent glass material or a flexible plastic material, such as polyethylene terephthalate (PET), polycarbonate (PC), polyimide (PI), polyethylene naphthalate (PEN), or polyethersulfone (PES).

The first transparent conductive layer 111 may be a conductive thin film such as indium tin oxide (ITO) or F doped tin dioxide (SnO₂) (FTO). The first transparent conductive layer 111 may have a single layer structure or a multiple layer structure. The conductive thin film is used to increase the efficiency of forming electrons. The first transparent conductive layer 111 has a high permeability, which facilitates sunlight to reach the dye molecules 114. Meanwhile, the first transparent conductive layer 111 has a relatively low electrical conductivity, which reduces the efficiency of forming electrons. Thus, the first grid electrodes 112 may be formed in order to compensate for the low electrical conductivity of the first transparent conductive layer 111.

The first grid electrodes 112 are formed of metal, such as silver (Ag) and aluminum (Al), and may be formed in a variety of patterns, such as a stripe pattern or a grid pattern. The first grid electrodes 112 have an electrical resistance lower than the first transparent conductive layer 111 so that a current smoothly flows therethrough. The first grid electrodes 112 may be covered by the protection film 160 for protection against the electrolyte solution 115.

The nano-sized semiconductor oxide layer 113 is formed on the first transparent conductive layer 111 and the protection film 160. The nano-sized semiconductor oxide layer 113 may be a titanium dioxide (TiO₂) layer, a tin dioxide (SnO₂) layer, or a zinc oxide (ZnO) layer. The nano-sized semiconductor oxide layer 113 has a structure in which a plurality of nanometer sized wide band gap semiconductor particles are stacked at an appropriate interval from each other. The dye molecules 114 containing, for example, a Ru complex compound, are chemically adsorbed onto the surfaces of the nanometer sized wide band gap semiconductor particles. When the surface area of the nanometer sized wide band gap semiconductor particles onto which the dye molecules 114 are adsorbed is larger, more current may be generated.

The dye molecules 114 may contain, for example, the Ru complex compound. Thiophene, phthalocyanine, porphyrin, indoline or quinoline and an organic substance containing derivatives thereof may be used as the dye molecules 114.

The opposite electrode 200 may include a second transparent conductive layer 101 formed on the second substrate 100, a plurality of second grid electrodes 102 formed on the second transparent conductive layer 101, the protection film 160 covering the second grid electrodes 102, and a catalyst film 103.

The second substrate 100 may be formed of a transparent glass material or a flexible plastic material.

The second transparent conductive layer 101 may be a conductive thin film such as ITO or FTO. The second grid electrodes 102 may be formed in order to compensate for the low electrical conductivity of the second transparent conductive layer 101. The protection film 160 may be formed on the second grid electrodes 102 to protect the second grid electrodes 102 from the electrolyte solution 115.

The catalyst film 103 may be formed on the second transparent conductive layer 101 and the protection film 160. The catalyst film 103 is, for example, a platinum (Pt) or carbon (C) thin film. The catalyst film 103 acts as a reduction catalyst that receives electrons through an external circuit. The platinum thin film is formed and thus the catalyst film 103 reflects sunlight incident through the photocathode electrode 210, thereby increasing the conversion efficiency of solar energy.

The electrolyte solution 115 is disposed between the photocathode electrode 210 and the opposite electrode 200. The electrolyte solution 115 is, for example, an iodine oxidation-reduction liquid electrolyte solution (I3⁻ / 3I⁻). The electrolyte solution 115 reduces the oxidized dye molecules 114. That is, the electrolyte solution 115 offers electrons to the oxidized dye molecules 114.

The present invention is not limited to the first electrode 210 and the second electrode 200 and it would be understood by one of ordinary skill in the art that various modifications may be possible. For example, the first electrode 210 and the second electrode 200 may not include grid electrodes, or the first electrode 210 and the second electrode 200 may not include the first and second transparent conductive layers 101 and 111. Alternatively, the first electrode 210 and the second electrode 200 may also not include the protection film 160.

The sealant 130 is used to prevent the electrolyte solution 115 from leaking from the area between the first substrate 110 and the second substrate 100. The sealant 130 is placed in internal peripheries of the first substrate 110 and the second substrate 100. The sealant 130 of the present embodiment is layered in the direction in which the first substrate 110 and the second substrate 100 are stacked. The sealant 130 may have a two-layer structure including a first sealing layer 131 and a second sealing layer 132 that are layered on top of each other. However, the present invention is not limited to the two-layer structure and the sealant 130 may have a three-layer structure.

Due to the two-layer structure or three-layer structure, the sealant 130 can have high sealing quality, and be thick with uniform thickness. In more detail, the dye-sensitized solar cell includes the photocathode electrode 210, the opposite electrode 200, and the electrolyte solution 115 between the first substrate 110 and the second substrate 100 wherein the first substrate 110 and the second substrate 100 are spaced apart from each other by a distance generally larger than 60 µm. Since the sealant 130 of the dye-sensitized solar cell maintains a gap between the first substrate 110 and the second substrate 100, the sealant 130 is necessarily thick, having a thickness larger than 60 µm. However, it is difficult to obtain a thick layer having uniform thickness. Also, when a thick layer is irradiated by a laser beam, plastic deformation occurs, which makes it difficult to obtain a uniform and high quality sealant. Also, when an organic-based sealing material is used instead of a thermoplastic glass frit, since the electrolyte solution 115 is likely lost through the organic-based film, the sealant 130 must be thin.

In view of the above, the sealant 130 having a two-layer structure is used in the present embodiment. In this case, a first sealing layer 131 is formed on any one of the first substrate 110 or the second substrate 100 to have a thickness smaller than the distance between the first substrate 110 and the second substrate 100. A second sealing layer 132 is formed on the other one of the first substrate 110 and the second substrate 100 to have a thickness equal to a difference between the distance between the first substrate 110 and the second substrate 100 and the thickness of the first sealing layer. The first sealing layer 131 includes a thermoplastic glass frit obtained by annealing a frit paste including a glass frit. The second sealing layer 132 may be a laser sealing layer or an organic-based sealing layer including an organic-based sealant. Since the first sealing layer 131 is separately disposed from the second sealing layer 132, the thickness of the second sealing layer 132, which is subject to plastic deformation due to the laser beam, or leak of the electrolyte solution through the organic-based film, is smaller than the gap between the first substrate 110 and the second substrate 100, thereby overcoming the problems associated with the sealant 130 being a single thick layer.

The first sealing layer 131 of the sealant 130 includes a thermoplastic glass frit, and the second sealing layer 132 thereof includes a thermoplastic glass frit and a laser absorption material. A wavelength of a laser beam used to perform a laser sealing operation may be in an infrared region, for example, between 808 nm and 1,064 nm. The laser absorption material may include manganese (Mn), iron (Fe), vanadium (V), chromium (Cr), nickel (Ni), cobalt (Co), or copper (Cu). However, the present invention is not limited thereto and the laser absorption material may be a high optical absorption material with respect to the wavelength of laser.

The thickness of the first sealing layer 131 may be equal to or greater than that of the second sealing layer 132. For example, the thickness of the first sealing layer 131 may be 60 µm, and the thickness of the second sealing layer 132 may be 40 µm. The first sealing layer 131 occupies a major portion of the gap between the first substrate 110 and the second substrate 100 so that the second sealing layer 132 on which the laser sealing operation is performed may be thin, thereby reducing plastic deformation, obtaining an overall thick sealant having uniform thickness, and achieving excellent quality of sealing when a laser sealing operation is performed. If the sealant 130 is formed of an inorganic material, the sealant 130 is water-proof, thereby preventing the electrolyte solution 115 from leaking.

According to a sealant 230 of another embodiment, a first sealing layer 131 includes a thermoplastic glass frit, and a second sealing layer 132 includes an organic-based resin material. The organic-based resin material may be, for example, an epoxy resin material, an acrylic resin material, an olefin-acrylic based resin material, an olefin-acrylic-ion based resin material, or an olefin-based resin material. The first sealing layer 131 occupies a major portion of the gap between the first substrate 110 and the second substrate 100 so that the second sealing layer 132 formed of the organic-based resin material may be thin. Accordingly, the sealant 230 is thick and has uniform thickness, and thus high quality sealing can be achieved. A sealing operation is performed at a relatively low temperature below 150 °C by using an organic-based sealing material, thereby reducing thermal damage of the dye and increasing durability against external shock since the organic-based sealing material has higher elasticity than an inorganic-based sealing material.

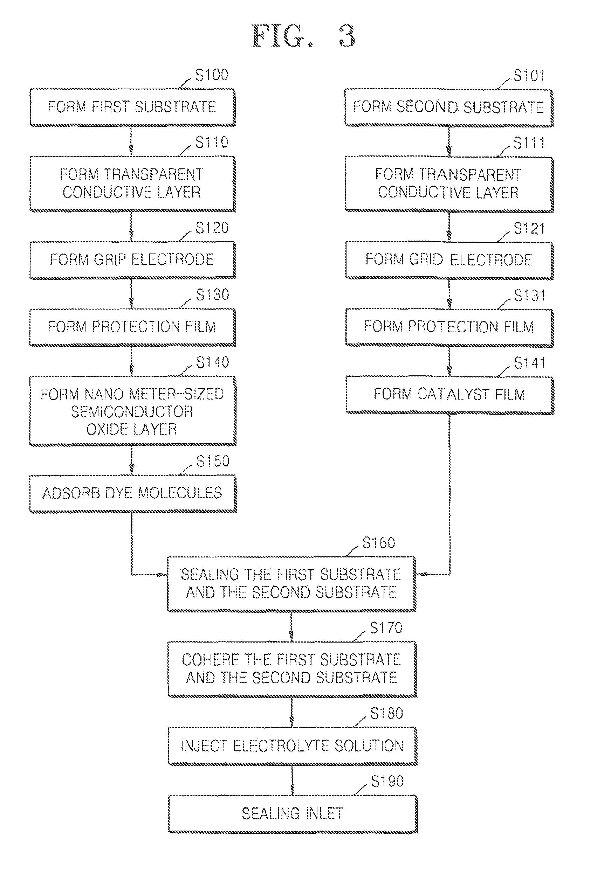

A method of manufacturing a dye-sensitized solar cell including a sealant 130 or a sealant 230 will now be described. FIG. 3 is a flowchart illustrating a method of manufacturing a dye-sensitized solar cell according to an embodiment of the present invention.

Referring to FIG. 3, the method of manufacturing a dye-sensitized solar cell includes forming the photocathode electrode 210 on the first substrate 110 (S 100 through S 150), forming the opposite electrode 200 on the second substrate 100 (S101 through S 141), sealing and combining the first substrate 110 with the second substrate 100 (S160 and S170), injecting the electrolyte 115 between the first substrate 110 and the second substrate 100 (S 180), and sealing an inlet (S 190). Although the electrolyte solution 115 is injected between the first substrate 110 and the second substrate 100 after the first substrate 110 and the second substrate 100 are sealed in the present embodiment, the present invention is not limited thereto and the first substrate 110 and the second substrate 100 may be sealed after the electrolyte solution 115 is injected between the first substrate 110 and the second substrate 100.

An operation of forming the first electrode 210, that is, the photocathode electrode, on the first substrate 110 will now be described. In S110, the first transparent conductive layer 111, such as ITO or FTO, is formed on the first substrate 110 is formed of a transparent glass. In S120, the first grid electrodes 112 formed of silver (Ag) or aluminum (Al) are formed in parallel on the first transparent conductive layer 111. The first grid electrodes 112 may have various patterns in addition to a stripe pattern. In S 130, the protection film 160 is formed on the first grid electrodes 112 in order to protect the first grid electrodes 112. In S140, the nano meter-sized semiconductor oxide layer 113 is formed on the first transparent conductive layer 11 and the protection film 160. The nano meter-sized semiconductor oxide layer 113 may be a titanium dioxide (TiO₂) layer, a tin dioxide (SnO₂) layer, or a zinc oxide (ZnO) layer. In S150, the dye molecules 114 are adsorbed onto the nano meter-sized semiconductor oxide layer 113. The dye molecules 114 are adsorbed onto the nano meter-sized semiconductor oxide layer 113 by soaking dye into the nano meter-sized semiconductor oxide layer 113 of the first substrate 110.

An operation of forming the second electrode 200 that is the opposite electrode on the second substrate 100 will now be described. In S111, the second transparent conductive layer 101, such as ITO or FTO, is formed on the second substrate 100 formed of a transparent glass. In S121, the second grid electrodes 102 formed of silver (Ag) or aluminum (Al) are formed in parallel on the second transparent conductive layer 101. The second grid electrodes 102 may have various patterns in addition to a stripe pattern. In S131, the protection film 160 is formed on the second grid electrodes 102 in order to protect the second grid electrodes 102. In S141, the catalyst film 103 is formed on the second grid electrodes 102 and the protection film 160. The catalyst film 103 may be a platinum (Pt) thin film or a copper (C) thin film.

The present invention is not limited to the above methods of forming the photocathode electrode 210 and the opposite electrode 200. A modification or change of methods of forming the photocathode electrode 210 and the opposite electrode 200 by one of ordinary skill in the art may be considered to also be within the scope of the present invention.

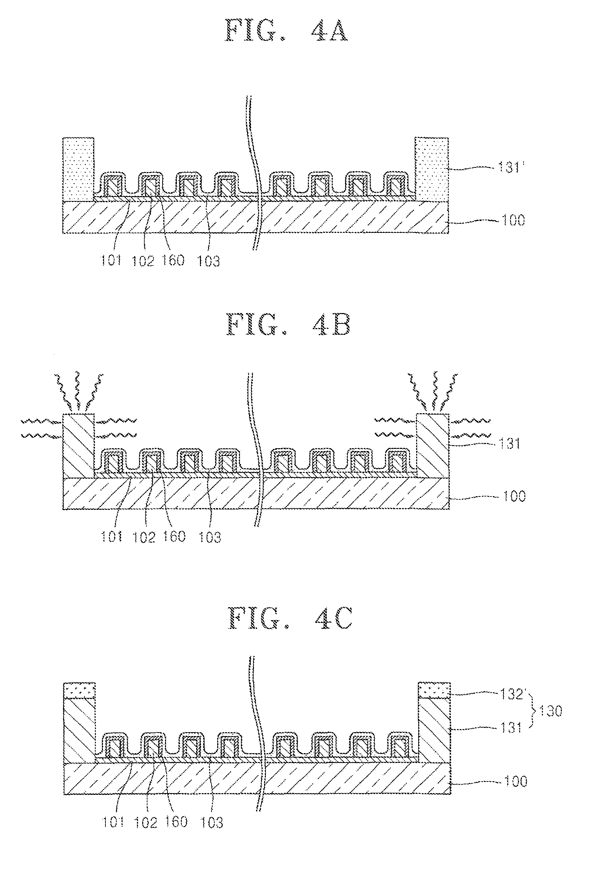

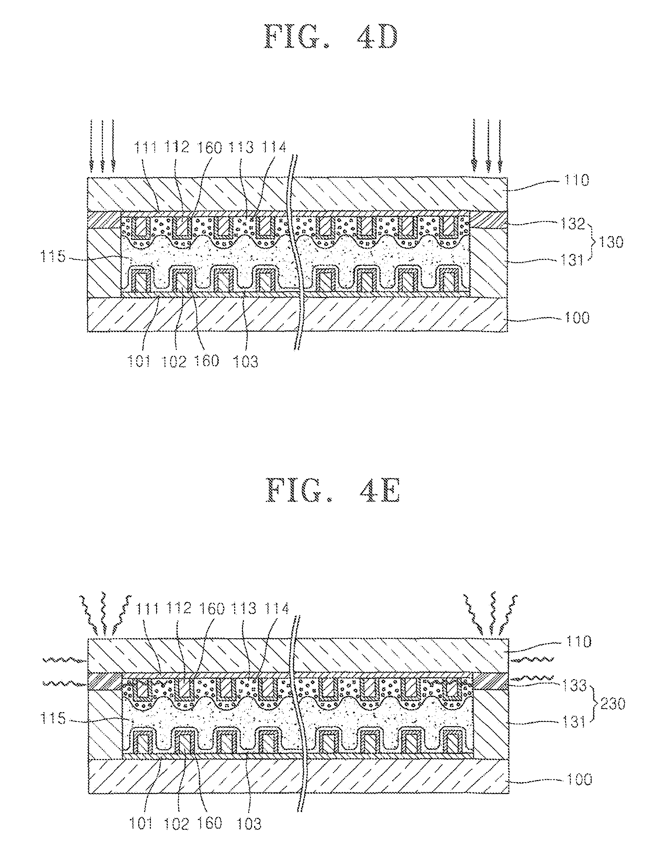

A method of forming a sealant 130 according to an embodiment of the present invention will now be described with reference to FIGS. 4A through 4D. Referring to FIG. 4A, a glass frit paste 131' is applied along the boundary of the second substrate 100 in order to form the first sealing layer 131. The glass frit paste 131' is a paste in which vehicles and a glass frit are mixed. The glass frit paste 131' is applied by using a screen printing method or a dispensing method. Referring to FIG. 4B, the glass frit paste 131 is dried and baked at a temperature of between about 450 and about 600 °C. A paste 132' is applied onto the first sealing layer 131 in order to form the second sealing layer 132. Referring to FIG. 4C, the paste 132' includes the glass frit paste 131' and a laser absorption material, for example, manganese (Mn), iron (Fe), vanadium (V), chromium (Cr), nickel (Ni), cobalt (Co), or copper (Cu). Referring to FIG. 4D, a laser beam is irradiated onto the second sealing layer 132 after the first substrate 110 is combined with the second sealing layer 132. The laser absorption material of the second sealing layer 132 absorbs the laser beam and is heated, and thus a sealing operation is completed.

A method of forming the sealant 230 according to another embodiment will now be described with reference to FIGS. 4A, 4B, 4C, and 4E. The sealant 230 is formed of an organic-based resin material, whereas the sealant 130 is formed of an inorganic-based resin material. Operations shown in FIGS. 4A and 4B are the same as described with reference to the sealant 130. However, since the sealant 230 is formed of the organic-based resin material that may be, for example, an epoxy resin material, an acrylic resin material, an olefin-acrylic based resin material, an olefin-acrylic-ion based resin material, or an olefin-based resin material, the glass frit paste 131 is heated and the glass frit paste 131 is pressed at a temperature of between about 100 and about 150 °C instead of being irradiated by a laser beam.

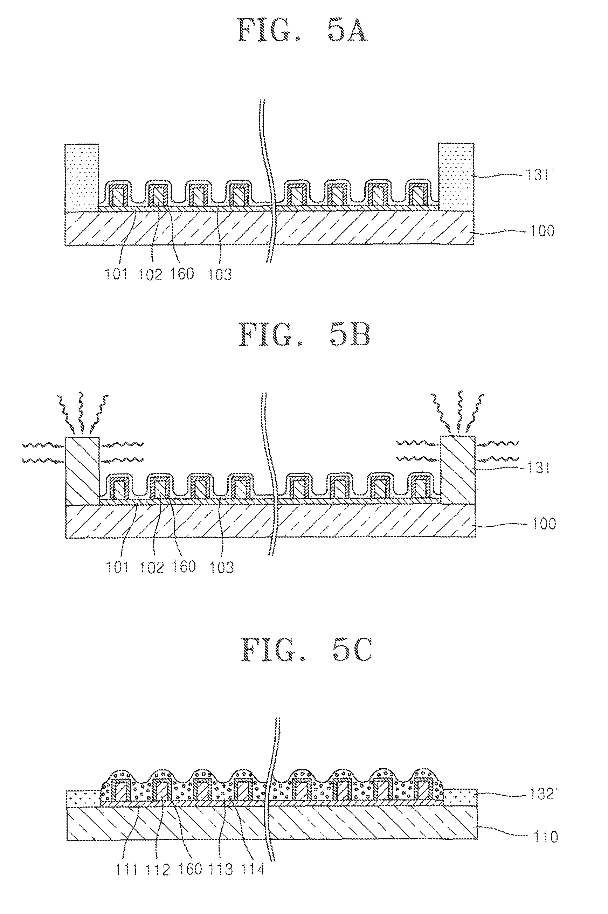

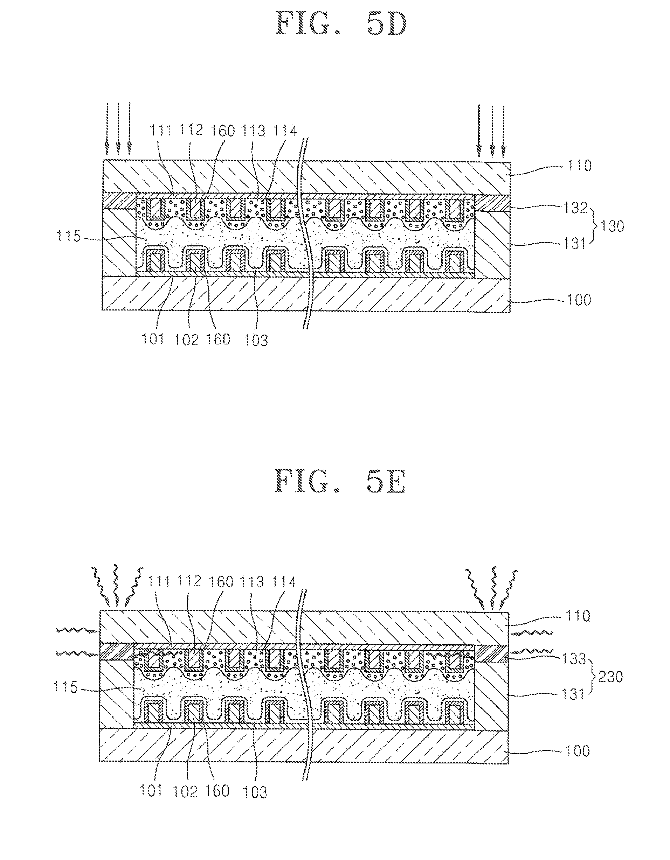

A method of forming the sealant 130 according to another embodiment will now be described with reference to 5A through 5D. Referring to FIG. 5A, the glass frit paste 131' is applied along the peripheries of inner surfaces of the second substrate 100 in order to form the first sealing layer 131. The method of forming and applying the glass frit paste 131' is the same as described with reference to FIG. 4A. Referring to FIG. 5B, the glass frit paste 131' is dried and baked at a predetermined temperature. Referring to FIG. 5C, the paste 132' is applied onto the first substrate 110 in order to form the second sealing layer 132. The second sealing layer 132 is disposed to face the first sealing layer 131. The first substrate 110 and the second substrate 100 are combined with each other so that the first sealing layer 131 and the second sealing layer 132 face each other. Referring to FIG. 5D, a laser beam is irradiated onto the second sealing layer 132. The laser absorption material of the second sealing layer 132 absorbs the laser beam and is heated, and thus a sealing operation is completed.

A method of forming the sealant 230 according to another embodiment will now be described with reference to FIGS. 5A, 5B, 5C, and 5E. Referring to FIG. 5A, a glass frit paste 131' is applied along the boundary of the second substrate 100. The method of forming and applying the glass frit paste 131' is the same as described with reference to FIG. 4A. Referring to FIG. 5B, the glass frit paste 131' is dried and heated at a predetermined temperature. Referring to FIG. 5C, an organic-based resin is applied on the first substrate 110 in order to form a second sealing layer 133. The second sealing layer 233 is disposed to face the first sealing layer 131. Referring to FIG. 5E, the first substrate 110 and the second substrate 100 are aligned so that the first sealing layer 131 and the second sealing layer 133 face each other, the second sealing layer 133 is heated and pressed at a temperature of between approximately 100 and approximately 150°C.

It should be understood that the exemplary embodiments described herein should be considered for descriptive purposes only, and are not intended to limit the claimed invention. Description of features or aspects within each embodiment should typically be considered as available for other similar features or aspects in other embodiments.

## Claims

1. A sealant disposed between two substrates, the sealant comprising: at least two layers disposed layered on top of each other between the two substrates,
wherein the at least two layers comprise materials having different components, and at least one of the at least two layers comprises a thermoplastic glass frit.

2. The sealant of claim 1, wherein each of the at least two layers comprises a thermoplastic glass frit and one of the at least two layers further comprises a laser absorption material.

3. The sealant of claim 1, wherein one of the at least two layers comprises a thermoplastic glass frit and another layer of the at least two layers comprises an organic-based resin material.

4. The sealant of claim 2, wherein,
one of the at least two layers comprising a thermoplastic glass frit and not comprising a laser absorption material is a first sealing layer,
and another layer comprising a laser absorption material is a second sealing layer, and
the thickness of the first sealing layer is greater than or equal to the thickness of the second sealing layer.

5. The sealant of claim 3, wherein one of the at least two layers comprising a thermoplastic glass frit is a first sealing layer, and another layer of the at least two layers comprising an organic-based resin material is a second sealing layer, and the thickness of the first sealing layer is greater than or equal to the thickness of the second sealing layer.

6. The sealant of claim 4 or 5, wherein the thickness of the first sealing layer is between 50 µm and 150 µm and the thickness of the second sealing layer is between 3 µm and 50 µm.

7. The sealant of claim 2, 4 or 6, wherein the laser absorption material comprises one selected from the group consisting of manganese (Mn), iron (Fe), vanadium (V), chromium (Cr), nickel (Ni), cobalt (Co), copper (Cu), and combinations thereof.

8. The sealant of claim 3, 5 or 6, wherein the organic-based resin material comprises one selected from the group consisting of an epoxy resin material, an acrylic resin material, an olefin-acrylic based resin material, an olefin-acrylic-ion based resin material, an olefin-based resin material, and combinations thereof.

9. A dye-sensitized solar cell comprising:
a first substrate and a second substrate disposed to face each other;
a first electrode and a second electrode formed on the inner surfaces of the first substrate and the second substrate, respectively;
an electrolyte solution filled between the first substrate and the second substrate; and
the sealant of one of the preceding claims disposed on the periphery of inner surfaces of the first substrate and the second substrate to seal the electrolyte solution,
wherein the first electrode comprises a semiconductor oxide layer onto which a plurality of dye molecules are adsorbed.

10. A method of manufacturing a dye-sensitized solar cell, the method comprising:
forming a first electrode on a first substrate;
forming a second electrode on a second substrate;
forming a first sealing layer on an inner surface of the first substrate or the second substrate;
forming a second sealing layer on an inner surface of the first sealing layer or on a region of the second substrate corresponding to the first sealing layer;
aligning and sealing the first substrate and the second substrate; and
injecting an electrolyte solution between the first substrate and the second substrate,
wherein the first sealing layer and the second sealing layer comprise materials having different components, and at least the first sealing layer comprises a thermoplastic glass frit.

11. The method of claim 10, wherein the dye-sensitized solar cell of claim 9 is produced.
